# EUROPEAN PATENT APPLICATION

(11) **EP 2 555 229 A1**
(43) Date of publication of application: **06.02.2013**
(21) Application number: 11762647.3
(22) Date of filing: 23.03.2011
(51) Int. Cl.: H01L 21/304, B24B 37/00, C09K 3/14

(54) **POLISHING AGENT, POLISHING METHOD AND METHOD FOR MANUFACTURING SEMICONDUCTOR INTEGRATED CIRCUIT DEVICE**

(30) Priority: 29.03.2010 JP 2010076088
(71) Applicant: Asahi Glass Company, Limited, Tokyo 100-8405 (JP)
(72) Inventor: SUZUKI Masaru, Tokyo 100-8405 (JP)
(74) Representative: Müller-Boré & Partner Patentanwälte
(86) International application number: PCT/JP2011/056979
(87) International publication number: WO 2011/122415

(57) **Abstract**

The present invention relates to a polishing slurry for performing chemical mechanical polishing on a surface to be polished including a surface made of silicon oxide and a surface made of metal, characterized in that it includes cerium oxide particles, a complexing agent, and water.

## Description

### Technical Field

The present invention relates to a polishing slurry used for manufacturing a semiconductor integrated circuit device, and a manufacturing method of a semiconductor integrated circuit device. More specifically, the present invention relates to a polishing slurry for chemical mechanical polishing suitable for rear-surface polishing at a time of forming a through silicon via, or a planarization of embedded wiring, a polishing method using the polishing slurry, and a manufacturing method of a semiconductor integrated circuit device.

### Background Art

In recent years, in accordance with high integration and high function of a semiconductor integrated circuit, development of miniaturization technology for realizing miniaturization and high density of a semiconductor element, is being promoted. In a manufacturing process of a semiconductor integrated circuit device, especially in a process of forming multilayered wirings, a planarization of interlayer insulating film and embedded wiring is important, and for the planarization, chemical mechanical polishing method (Chemical Mechanical Polishing, referred to as CMP, hereinafter) is used. Specifically, as the multilayered wirings are increasingly formed due to the miniaturization and the high density of the semiconductor integrated circuit, unevenness (level difference) on a surface of each layer tends to increase. In order to prevent a problem such that the level difference exceeds a depth of focus in lithography and a sufficient resolution cannot be obtained, a technology of high planarization in the process of forming the multilayered wirings, becomes important.

For example, regarding the embedded wiring, copper (Cu) is drawing attention as a material for such wiring, because of its low resistivity as compared to a conventionally used Al alloy and because of its excellent electromigration resistance. A vapor pressure of copper chloride gas is low, so that it is difficult to form copper into a shape of wiring by a reactive ion etching method (RIE), and accordingly, in order to form the wiring, a damascene method is used. This is a method such that a concave portion such as a groove pattern or a via for wiring, is formed on an insulating layer made of silicon oxide, a barrier layer is then formed, copper is then deposited by a sputtering method, a plating method or the like, so as to be embedded in the groove portion, and thereafter, excess copper layer and barrier layer are removed until a surface of the insulating layer except for the groove portion is exposed, to thereby planarize the surface to form the embedded wiring.

In the formation of such copper embedded wiring, as the barrier layer for preventing copper from diffusing into the insulating layer, there is formed a layer made of tantalum (Ta), a Ta alloy, or a tantalum compound such as TaN, or made of titanium (Ti), a Ti alloy, or a titanium compound such as TiN. In the portion other than the wiring portion in which copper is embedded, the exposed barrier layer has to be removed by CMP. However, since the above-described metal or metal compound that forms the barrier layer has properties in polishing, which are different from those of copper, it is considered to remove the barrier layer in a process different from the process of polishing copper, and there has been proposed a two-stage polishing method including a first polishing process of removing an excess wiring metal layer, and a second polishing process of removing an excess barrier layer. In the second polishing process, in order to completely remove the excess barrier layer on an insulating layer and to eliminate an erosion of the wiring metal layer called as dishing by shaving the insulating layer to align a height of the insulating layer with a height of the wiring metal layer, a polishing slurry with which a polishing rate of copper is suppressed and polishing rates of the barrier layer and the insulating layer are improved, is required.

However, although a conventional polishing slurry that contains silicon oxide particles as abrasive particles provides a sufficient polishing rate with respect to the barrier layer, the polishing slurry cannot provide a sufficient polishing rate with respect to silicon oxide being the insulating layer. For this reason, the polishing had to be performed with a polishing slurry in which a concentration of silicon oxide particles was increased to 5 to 15 mass%, so that there were problems that gelation occurred since the concentration of the particles were too high, and that cost was increased.

Recently, in order to achieve further integration, a structure in which a thickness of silicon substrate on which a semiconductor integrated circuit is formed is reduced to 200 to 10 µm, and a plurality of the thickness-reduced substrates are stacked, has been adopted. Further, for transmitting information (signals), respective silicon substrates are connected through metal wires. However, the connection through the metal wires is unsuitable for high-speed and high-density information transmission because of high performance of the semiconductor integrated circuit device, and it has been studied to form an electrode, called as TSV (Through Silicon Via) passing through the silicon substrate, and to use it as a substitute for the metal wire.

In order to form such a through silicon via, a method in which a concave portion is formed on an integrated circuit forming surface (front surface) of the silicon substrate, an insulating layer made of silicon oxide is formed on the concave portion, metal such as copper or tungsten is then embedded via a barrier layer, and the resultant is subjected to CMP from both of front and rear surfaces of the silicon substrate, is often adopted.

When polishing on the rear surface (surface on the opposite side of the integrated circuit forming surface) of the silicon substrate, since the metal electrode has to be exposed conclusively, it is required to polish mainly on the silicon substrate and the silicon oxide layer, and to polish on metal for electrode at a polishing rate which is adjusted in accordance with the purpose, depending on how much of the metal electrode is exposed. Currently, a method of exposing the metal electrode of about several µm by polishing with a polishing slurry that provides almost no (quite small) polishing rate of metal, is mainly adopted.

However, the formation of exposed convex portion in a µm order on the metal electrode was difficult with the normal polishing method using the conventional polishing slurry. Specifically, since the polishing is performed by pressing a polishing platen which is rotated at a high speed against a surface to be polished at a high pressure, defects such that the exposed convex portion of the metal electrode bents or broken, or cracks occurs on the convex portion, easily occurred.

To solve this problem, there is considered a method in which the metal electrode is also once polished to planarize the rear surface of the silicon substrate, and then silicon and silicon oxide layer and the like around the electrode are removed by etching, to thereby form a metal electrode with very small defects described above. In order to use this method, a polishing slurry capable of polishing each of silicon, silicon oxide, and metal at an equal rate, is required. Further, since film deposition conditions, and densities, sizes and the like of wirings are not the same, and a polishing rate at a time of polishing a rear surface when a metal electrode is actually formed, and a polishing rate in a blanket wafer are not always the same, a polishing slurry capable of adjusting each polishing rate of silicon, silicon oxide, and metal in the blanket wafer with a simple method, and with which each of silicon, silicon oxide and metal can be polished at an equal rate at a time of performing actual polishing, is required.

In conventionally used polishing slurry for silicon and polishing slurry for metal, abrasive particles of silicon oxide such as colloidal silica have been used (refer to Reference 1, Rerence 2, for example). However, when these polishing slurries are used, there was a problem such that although it is possible to polish silicon and metal at a high rate, it is not possible to polish silicon oxide at a high rate. Therefore, in order to polish silicon, silicon oxide, and metal at an equal polishing rate, there is no other option but to suppress the polishing rates of silicon and metal in accordance with the polishing rate of silicon oxide, and thus inefficient polishing had to be conducted.

Meanwhile, a technique of improving a polishing rate of silicon oxide by using cerium oxide particles as abrasive grains, has been well-known. However, when metal is polished with the cerium oxide particles, there is a problem that a scratch which is large enough to be seen with the naked eye, is formed on a surface of polished metal. Accordingly, it has been considered that the cerium oxide particles cannot be used for polishing metal.

### Relevant References

### Patent Reference

Reference 1: JP-A 49-111580 (KOKAI)
Reference 2: JP-B 3397501 (PATENT)

### Summary of the Invention

### Problems to be Solved by the Invention

The present invention has been made to solve the aforementioned problems, and an object thereof is to provide a polishing slurry suitable for polishing, by CMP, a surface to be polished including each of a surface made of silicon oxide and a surface made of metal, in a manufacture of a semiconductor integrated circuit device, and having an improved controllability of a polishing rate, a polishing method using the polishing slurry, and a manufacturing method of the semiconductor integrated circuit device.

### Means for Solving the Problems

A first aspect of the present invention is a polishing slurry for chemical mechanical polishing on a surface to be polished including a surface made of silicon oxide and a surface made of metal, and comprises cerium oxide particles, a complexing agent, and water.

A second aspect is characterized in that, in the polishing slurry in the first aspect, the surface to be polished further includes a surface made of silicon, and the polishing slurry further comprises a pH adjusting agent with which a pH is set to fall within a range of 9 to 14.

A third aspect is characterized in that, in the polishing slurry in the second aspect, the pH adjusting agent is a basic compound.

A fourth aspect is characterized in that, in the polishing slurry in any one of the first to third aspects, the metal is at least one kind of metal selected from copper and an alloy thereof, tantalum and an alloy thereof, titanium and an alloy thereof, tungsten, aluminum, and nickel.

A fifth aspect is characterized in that, in the polishing slurry in any one of the first to fourth aspects, the surface to be polished further includes a surface made of at least one kind of metal compound selected from tantalum nitride and titanium nitride.

A sixth aspect is characterized in that, in the polishing slurry in any one of the first to fifth aspects, the complexing agent has 5 or more of complex ion stability constant with at least one kind of metal contained in the surface to be polished.

A seventh aspect is characterized in that, in the polishing slurry in the sixth aspect, the complexing agent has a nitrogen atom and a carbonyl group, and is an organic compound in which the nitrogen atom and the carbonyl group are directly bonded or bonded via an organic group having a carbon number of 2 or less.

An eighth aspect is characterized in that, in the polishing slurry in the sixth or seventh embodiment, the complexing agent is at least one selected from iminodiacetic acid, picolinic acid, succinimide, and glycylglycine.

A ninth aspect is characterized in that the polishing slurry in any one of the first to eighth aspects further comprises an oxidizing agent.

A tenth aspect is characterized in that, in the polishing slurry in the ninth aspect, the oxidizing agent is peracid or a salt thereof.

An eleventh aspect is that, in the polishing slurry in the tenth aspect, the oxidizing agent is persulfuric acid or a salt thereof.

A twelfth aspect is a manufacturing method of a semiconductor integrated circuit device including a silicon substrate having an integrated circuit, and comprises a step of polishing, with the polishing slurry in any one of the first to eleventh aspects, a surface to be polished on the silicon substrate including a surface made of silicon oxide and a surface made of metal.

A thirteenth aspect is characterized in that, in the manufacturing method of the semiconductor integrated circuit device in the twelfth aspect, the surface to be polished further includes a surface made of silicon being a surface on an opposite side of an integrated circuit forming surface of the silicon substrate, and the step of polishing comprises polishing, with the polishing slurry in any one of the first to eleventh aspects, a surface to be polished including a surface made of metal conducted to the integrated circuit.

A fourteenth aspect is a polishing method of performing chemical mechanical polishing on a surface to be polished including a surface made of silicon oxide and a surface made of metal, comprises a step of polishing with a polishing slurry containing cerium oxide particles, a complexing agent, and water.

A fifteenth aspect is characterized in that, in the polishing method in the fourteenth aspect, the surface to be polished further includes a surface made of silicon, and the polishing slurry further contains a pH adjusting agent with which a pH is set to fall within a range of 9 to 14.

A sixteenth aspect is characterized in that, in the polishing method in the fifteenth aspect, the pH adjusting agent is a basic compound.

A seventeenth aspect is characterized in that, in the polishing method in any one of the fourteenth to sixteenth aspects, the metal is at least one kind of metal selected from copper and an alloy thereof, tantalum and an alloy thereof, titanium and an alloy thereof, tungsten, aluminum, and nickel.

An eighteenth aspect is characterized in that, in the polishing method in any one of the fourteenth to seventeenth aspects, the surface to be polished further includes a surface made of at least one kind of metal compound selected from tantalum nitride and titanium nitride.

A nineteenth aspect is characterized in that, in the polishing method in any one of the fourteenth to eighteenth aspects, the complexing agent has 5 or more of complex ion stability constant with at least one kind of metal contained in the surface to be polished.

A twentieth aspect is characterized in that, in the polishing method in the nineteenth aspect, the complexing agent has a nitrogen atom and a carbonyl group, and is an organic compound in which the nitrogen atom and the carbonyl group are directly bonded or bonded via an organic group having a carbon number of 2 or less.

A twenty-first aspect is characterized in that, in the polishing method in the nineteenth or twentieth aspect, the complexing agent is at least one selected from iminodiacetic acid, picolinic acid, succinimide, and glycylglycine.

A twenty-second aspect is characterized in that, in the polishing method in any one of the fourteenth to twenty-first aspects, the polishing slurry further contains an oxidizing agent.

A twenty-third aspect is characterized in that, in the polishing method in the twenty-second aspect, the oxidizing agent is peracid or a salt thereof.

A twenty-fourth aspect is characterized in that, in the polishing method in the twenty-third aspect, the oxidizing agent is persulfuric acid or a salt thereof.

A twenty-fifth aspect is a manufacturing method of a semiconductor integrated circuit device including a silicon substrate having an integrated circuit, and comprises a step of polishing, by the polishing method in any one of the fourteenth to twenty-fourth aspects, a surface to be polished on the silicon substrate including a surface made of silicon oxide and a surface made of metal.

A twenty-sixth aspect is characterized in that, in the manufacturing method of the semiconductor integrated circuit device in the twenty-fifth aspect, the surface to be polished further includes a surface made of silicon being a surface on an opposite side of an integrated circuit forming surface of the silicon substrate, and the step of polishing comprises polishing, by the polishing method in any one of the fourteenth to twenty-fourth aspects, a surface to be polished including a surface made of metal conducted to the integrated circuit.

### Effect of the Invention

According to the present invention, in a CMP used for a formation of through silicon via, a planarization of embedded wiring or the like in a semiconductor integrated circuit device, it is possible to polish a surface to be polished including a surface made of silicon oxide and a surface made of metal while controlling a polishing rate with respect to each of silicon oxide and metal, resulting in that the surface to be polished which is planarized with no polishing defect formed thereon, can be obtained.

### Brief Description of the Drawings

[FIG. 1] FIGs. 1A, 1B, 1C and 1D are schematic cross-sectional views of a semiconductor integrated circuit device illustrating a polishing process at a time of forming a through silicon via according to a first embodiment.

[FIG. 2] FIG. 2 is a diagram illustrating an example of a polishing apparatus capable of being used in the first embodiment.

[FIG. 3] FIGs. 3A, 3B and 3C are schematic cross-sectional views of a semiconductor integrated circuit device illustrating a polishing process at a time of forming an embedded wiring according to a second embodiment.

### Best Mode for Carrying out the Invention

Hereinafter, embodiments of the present invention will be described based on a first embodiment suitable for rear-surface polishing at a time of forming a through silicon via, and a second embodiment suitable for a planarization of an embedded wiring. The present invention is not limited to these embodiments, and other embodiments can also belong to the category of the present invention as long as they are in accordance with the purport of the present invention.

(1) First Embodiment: Polishing slurry for CMP Used for Rear-Surface Polishing When Forming Through Silicon Via and Polishing Method

### (1-1) Polishing slurry

A polishing slurry in the first embodiment of the present invention is one for performing, in a manufacture of a semiconductor integrated circuit device (also referred to as semiconductor device, hereinafter), for example, chemical mechanical polishing on a surface to be polished including each of a surface made of silicon, a surface made of silicon oxide, and a surface made of metal (which is also described as, including each of silicon, silicon oxide and metal, hereinafter), and contains cerium oxide particles, a complexing agent, a pH adjusting agent and water, in which a pH is adjusted to fall within a range of 9 to 14. This polishing slurry may also contain a dispersing agent. Further, it is possible that an oxidizing agent is contained in the polishing slurry. Note that the "surface to be polished" means a surface at an intermediate stage which appears in a process of manufacturing the semiconductor device.

By using this polishing slurry, when the surface to be polished of the semiconductor device contains silicon, silicon oxide, and metal, polishing rate with respect to each of silicon, silicon oxide and metal is controlled easily. Accordingly, when a through silicon via is formed through rear-surface polishing of a silicon substrate, it is possible to control a height of the electrode and a thickness of silicon with high accuracy, as will be described later. Further, since no agglomeration of cerium oxide particles being abrasive particles occurs in this polishing slurry, the polishing slurry is also excellent in dispersion stability and thus causes no polishing defects, which is also advantageous.

In the first embodiment of the present invention, the cerium oxide particles in the polishing slurry are polishing abrasive particles. In basic condition, negatively charged silanol groups are formed on a surface of silicon, so that by using the cerium oxide particles instead of silica particles which have been conventionally used as the polishing abrasive particles, a polishing effect by chemical reaction is increased. Accordingly, this polishing slurry provides a high polishing rate with respect to silicon, similar to silicon oxide.

As the cerium oxide particles, for example, cerium oxide abrasive particles as disclosed in JP-A 11-12561 (KOKAI) or JP-A 2001-35818 (KOKAI) can be preferably used. Specifically, a cerium oxide powder obtained by adding alkali to an aqueous solution of cerium (IV) ammonium nitrate to generate a cerium hydroxide gel, followed by filtration, washing, and firing, can be preferably used. Further, cerium oxide particles obtained by milling high purity cerium carbonate and then firing it, followed by further milling and classification, can also be preferably used, but, the cerium oxide particles are not particularly limited thereto.

An average particle size (diameter) of the cerium oxide particles is preferably 0.01 to 0.5 µm, more preferably 0.02 to 0.3 µm, and is particularly preferably 0.05 to 0.2 µm, from the viewpoint of polishing properties and dispersion stability. Note that for measurement of the average particle size, a particle size distribution analyzer of laser scattering/diffraction type, dynamic light scattering type, photon correlation type or the like, can be used. When the average particle size is too large, polishing defects such as scratches are likely to be formed on the surface of the silicon substrate. On the other hand, when the average particle size is too small, the polishing rate may be lowered. Further, since a proportion of the surface area per unit volume becomes high, the particles are likely to be influenced by the surface state, and depending on conditions such as a pH and a concentration of additives, the particles are likely to agglomerate. When the agglomeration of cerium oxide particles takes place, polishing defects such as scratches are likely to be formed on the surface of the silicon substrate.

A concentration (percentage of content) of the cerium oxide particles in the polishing slurry is preferably set to fall within a range of 0.01 to 10.0 mass%, in order to obtain a sufficient effect when controlling the polishing rate. When the concentration is less than 0.01 mass%, it is difficult to achieve a sufficient polishing rate, and when the concentration exceeds 10.0 %mass%, the dispersibility may be lowered. The concentration is more preferably 0.02 to 5.0 mass%, still more preferably 0.03 to 2.0 mass%, and is particularly preferably 0.03 to 1.0 mass%.

In the polishing slurry in the first embodiment of the present invention, the complexing agent suppresses the agglomeration of the cerium oxide particles by trapping a metal ion generated during the polishing to form a complex (chelate). Generally, it can be considered that the reason why the polishing defects are likely to be formed when polishing metal with cerium oxide particles, is because a metal ion generated during the polishing acts on cerium oxide to facilitate a strong agglomeration, resulting in that a huge solid is generated. When the complexing agent is added, the metal ion generated during the polishing is immediately trapped by the complexing agent, resulting in that the agglomeration of cerium oxide particles due to the action of the metal ion is suppressed.

A preferable complexing agent in the present invention is one having 5 or more of complex ion stability constant with at least one kind of metal being an object to be polished. The higher the complex ion stability constant, the higher the effect of trapping the metal ion. A complexing agent having 8 or more of complex ion stability constant is more preferably used, and a complexing agent having 10 or more of complex ion stability constant is still more preferably used.

As such a complexing agent, organic acid, ammonia, alkylamine, amino acid, imine, a nitrogen-containing compound such as azole and a salt thereof, and mercaptan are well known. As a complexing agent that forms a complex ion with copper, there can be cited ammonia, acetylacetone, 5-adenosine triphosphate, 2-aminoethanol, ethyl amine, ethylene diamine, catechol, citric acid, glycylglycine, glycine, L-glutamic acid,
L-2,4-diaminobutyric acid, diethylenetriamine,
triethylenetetramine, picolinic acid, histidine, 2,2'-dipyridyl, 1,10-phenanthroline, L-phenylalanine, malonic acid or the like. Further, there can be cited ethylene diamine tetra-acetic acid, diethylenetriamine pentaacetic acid, nitrilotriacetic acid, N-hydroxyethylethylenediaminetriacetic acid, hydroxyethyliminodiacetic acid, acetic acid, citric acid, ethyl acetoacetate, glycolic acid, glyoxylic acid, lactic acid, malic acid, oxalic acid, salicylic acid, sodium diethyldithiocarbamate, succinic acid, tartaric acid, thioglycolic acid, alanine, aspartic acid, trimethylene diamine, 1,2-ethanedithiol,
1,4-dithiothreitol, bis(methylthio)methane,
dimethyldithiocarbamate, 5-methyl-3,4-thiadiazole-2-thiol, glutaric acid, 3-hydroxybutyric acid, propionic acid, phthalic acid, isophthalic acid, 3-hydroxysalicylic acid,
3,5-dihydroxysalicylic acid, iminodiacetic acid, succinimide, gallic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glyceric acid, glutaric acid, adipic acid, pimelic acid, maleic acid, phthalic acid, tartaric acid, L-alanine, β-alanine, L-2-aminobutyric acid, L-norvaline, L-valine, L-leucine, L-norleucine, L-isoleucine, L-alloisoleucine, L-phenylalanine, L-proline, sarcosine, L-ornithine, L-lysine, taurine, L-serine, L-threonine, L-allothreonine, L-homoserine, L-tyrosine, 3,5-diiode-L-tyrosine, β-(3,4-dihydroxyphenyt)-L-alanine, L-thyroxine,
4-hydroxy-L-proline, L-cysteine, L-methionine, L-ethionine, L-lanthionine, L-cystathionine, L-cystine,
L-cysteic acid, L-aspartic acid, L-glutamic acid, S-(carboxymethyl)-L-cysteine, 4-aminobutyric acid, L-asparagine, L-glutamine, azaserine, L-arginine, L-canavanine, L-citrulline, 5-hydroxy-L-lysine, creatine, L-kynurenine, L-histidine, 1-methyl-L-histidine, 3-methyl-L-histidine, ergothioneine, L-tryptophan, actinomycin C1, apamine, angiotensin I, angiotensin II, antipain, dithizone, cuproine(2,2'-biquinoline), neocuproine(2,9-dimethyl-1,10-phenanthroline),
bathocuproine(2,9-dimethyl-4,7-diphenyl-1,10-phenanthroline), cuperazone(biscyclohexanone oxalylhydrazone), nonyl mercaptan, dodecyl mercaptan, triazine thiol, triazine dithiol, triazine trithiol or the like.

Because of an easiness of formation of five-membered ring with copper ion, a more preferable complexing agent in the present invention is an organic compound having each of a nitrogen atom and a carbonyl group, and in which an organic group that exists between the nitrogen atom and the carbonyl group has a carbon number of 2 or less, namely, an organic compound in which a nitrogen atom and a carbonyl group are directly bonded, or bonded via an organic group having a carbon number of 2 or less.

In a field of complexation chemistry, it is known that nitrogen atoms and oxygen atoms are coordinated to metal ions to form stable complexes. However, when a nitrogen atom and an oxygen atom in the same molecule are separated too much, the complexation ability is lowered, so that a complexing agent in which the number of carbon existed between the nitrogen atom and the carbonyl group is 2 or less, is preferable. A more preferable complexing agent is an organic compound in which the number of carbon existed between the nitrogen atom and the carbonyl group is 1 or less. Among the above-described complexing agents, ethylene diamine tetra-acetic acid, diethylenetriamine pentaacetic acid, nitrilotriacetic acid, iminodiacetic acid, succinimide, N-hydroxyethylethylenediaminetriacetic acid, 5-adenosine triphosphate, glycylglycine, glycine, L-2,4-diaminobutyric acid, picolinic acid, histidine, L-alanine, β-alanine,
L-2-aminobutyric acid, L-norvaline, L-valine, L-leucine, L-norleucine, L-isoleucine, L-alloisoleucine,
L-phenylalanine, L-proline, sarcosine, L-omithine, L-lysine, taurine, L-serine, L-threonine, L-allothreonine,
L-homoserine, L-tyrosine, 3,5-diiode-L-tyrosine, β-(3,4-dihydroxyphenyl)-L-alanine,
L-thyroxine, 4-hydroxy-L-proline, L-cysteine, L-methionine, L-ethionine, L-lanthionine, L-cystathionine,
L-cystine, L-cysteic acid, L-aspartic acid, L-glutamic acid,
S-(carboxymethyl)-L-cysteine, 4-aminobutyric acid, L-asparagine, L-glutamine, azaserine, L-arginine,
L-canavanine, L-citrulline, 8-hydroxy-L-lysine, creatine, L-kynurenine, L-histidine, 1-methyl-L-histidine,
3-methyl-L-histidine, ergothioneine, L-tryptophan, actinomycin C1, apamine, angiotensin I, or angiotensin II, corresponds to such an organic compound.

A particularly preferable complexing agent is iminodiacetic acid, picolinic acid, succinimide, and glycylglycine. Among the above, iminodiacetic acid is more preferable since it has the smallest molecular weight and the highest complexation ability per unit weight.

In order to obtain a sufficient effect in the complexation, it is preferable to appropriately set a concentration (percentage of content) of the complexing agent in the polishing slurry within a range of 0.01 to 10 mass%, by taking the solubility and the complexation ability into consideration. The concentration is more preferably within a range of 0.05 to 5 mass%, still more preferably within a range of 0.1 to 2 mass%, and is particularly preferably within a range of 0.2 to 1 mass%. A ratio of cerium oxide particles to the complexing agent is preferably 1:100 to 2:1. The ratio is more preferably 1:50 to 1:1, and is particularly preferably 1:20 to 1:3.

In the first embodiment of the present invention, as the pH adjusting agent contained in the polishing slurry, one kind or more of basic compound selected from sodium hydroxide, potassium hydroxide, lithium hydroxide, tetramethylammonium hydroxide, monoethanolamine, ethyl ethanolamine, diethanolamine, propylene diamine and ammonia can be preferably exemplified. Among the above, potassium hydroxide is particularly preferable from the viewpoint of the easiness of pH adjustment.

It can be considered that the reason why the polishing of silicon is facilitated by the addition of the pH adjusting agent is because there are provided a polishing effect achieved by the cerium oxide particles and an adsorption effect of the basic compound on the surface of silicon being the object to be polished. On the surface of silicon, a silanol group is formed by a chemical change caused by the basic compound, so that the surface becomes easy to be shaved because of a mechanical action of the cerium oxide particles being the abrasive particles. As a result of this, it can be considered that the polishing of the surface of silicon is facilitated. This is based on the same mechanism in which a hydration layer of a surface of a silicic acid compound of a glass or the like is polished at a high rate by cerium oxide particles. As above, the polishing of silicon is facilitated by not only the chemical etching action of the basic compound but also the mechanical action of the cerium oxide particles.

In the first embodiment of the present invention, water is contained, in the polishing slurry, as a dispersion medium of the cerium oxide particles being the abrasive particles. Although there is no particular limitation regarding the water, it is preferable to use pure water, ultrapure water, ion-exchange water or the like, from the viewpoint of the small influence on another component, the small mixture of impurities, and the small influence on the pH or the like.

The polishing slurry in the first embodiment that polishes the surface to be polished containing silicon, is used in an alkaline pH range. The pH range is preferably a range of pH 9 to 14, by taking the polishing properties of the polishing slurry into consideration. When the pH is less than 9, a sufficient polishing rate with respect to silicon may not be achieved.

Another component may also coexist in the polishing slurry in the first embodiment of the present invention. As a typical example, there can be cited a dispersing agent. The dispersing agent is added for making the cerium oxide particles to be stably dispersed in a dispersion medium such as pure water.

As the dispersing agent, it is possible to use an anionic, cationic, nonionic or ampholytic surfactant, or a water-soluble polymer having a surface-active action can be used. Here, the surfactant refers to one having a weight average molecular weight (Mw) of 500 or less. Further, it is set that a compound having an amino group is not included in the surfactant and the water-soluble polymer having a surface-active action. As the surfactant having Mw of 500 or less, there can be cited alkyl benzene sulfonate, a tetraalkylammonium salt, polyoxyethylene alkyl ether or the like. As the water-soluble polymer having a surface-active action, there can be cited a water-soluble polymer having a carboxylic acid group such as polyacrylic acid salt, and other water-soluble polymers such as polyvinyl pyrrolidone. In particular, a water-soluble polymer having a carboxylic acid ammonium salt group is preferable. Concretely, there can be cited a polymer in which at least a part of carboxylic acid groups of polyacrylic acid is substituted with a carboxylic acid ammonium salt group (hereinafter, referred to as ammonium polyacrylate) or the like. The water-soluble polymer having a surface-active action preferably has the Mw that exceeds 500, and particularly preferably has the Mw in a range of 800 to 100,000.

When the dispersing agent (including a water-soluble polymer having a dispersing action) is used, a blending proportion thereof is preferably set to 0.1 to 2.0 mass%, and is more preferably set to 0.3 to 1.5 mass% with respect to the mass of the cerium oxide particles. When the blending proportion of the dispersing agent is lower than this range, the dispersibility of the cerium oxide particles being the abrasive particles is easy to become insufficient. Further, when the blending proportion of the dispersing agent exceeds this range, a bad influence may be exerted on the planarity and the polishing rate during the polishing.

In the polishing slurry in the first embodiment of the present invention, an oxidizing agent can be added. Metal is oxidized by the added oxidizing agent, and the oxidized metal is made to be easily eluted as a metal ion complex with the use of the complexing agent, resulting in that a polishing rate of metal can be controlled.

In the present invention, a preferable oxidizing agent is peracid and a salt thereof. Cerium (IV) (quadrivalent cerium) in cerium oxide is a powerful oxidizing agent, and an oxidizing agent such as hydrogen peroxide having an oxidation-reduction potential lower than that of cerium (IV) is not preferable since it is oxidized by cerium (IV) and thus does not function as the oxidizing agent.

A particularly preferable oxidizing agent is persulfuric acid and a salt thereof. From the viewpoint of water solubility, ammonium persulfate is more preferable.

It is preferable to appropriately set a concentration (percentage of content) of the oxidizing agent in the polishing slurry within a range of 10 mass% or less by taking homogeneity and pH of a polishing slurry into consideration, so that a sufficient effect can be achieved when controlling the polishing rate of metal. When the concentration of the oxidizing agent is too high, there is a possibility of causing agglomeration, so that the concentration is more preferably 5 mass% or less, and is still more preferably 2 mass% or less.

In the polishing slurry in the first embodiment, there is no need to add a metal protective agent. Generally, in a polishing slurry for polishing metal, a metal protective agent for suppressing corrosion of metal is added, but, the addition of metal protective agent is not necessary in the polishing slurry according to the present invention since no corrosion of metal is caused by the polishing slurry.

The polishing slurry in the first embodiment of the present invention is not required to be supplied to a polishing process in a state where all of the aforementioned constituents are previously mixed. It is also possible to design such that all of the constituents are mixed to satisfy the composition of the polishing slurry, only after they are supplied to the polishing process. For example, it is also possible to design such that a solution containing cerium oxide particles, water, and a dispersing agent (ammonium polyacrylate, for example) according to need, and another solution containing a basic compound being a pH adjusting agent, a complexing agent, and an oxidizing agent, are separately prepared, and they are used by appropriately adjusting a mixing ratio when performing polishing. Further, it is also possible that two solutions of another set are mixed to be used by appropriately adjusting a ratio thereof. For example, it is also possible to prepare a polishing slurry by adding a basic compound being a pH adjusting agent and an oxidizing agent to a solution provided by mixing cerium oxide particles, a complexing agent, water, and a dispersing agent according to need.

### (1-2) Surface to be Polished of Semiconductor Device

The polishing slurry in the first embodiment of the present invention is suitable for rear-surface polishing in which a rear surface of a silicon substrate is polished to expose a metal electrode in a formation of through silicon via.

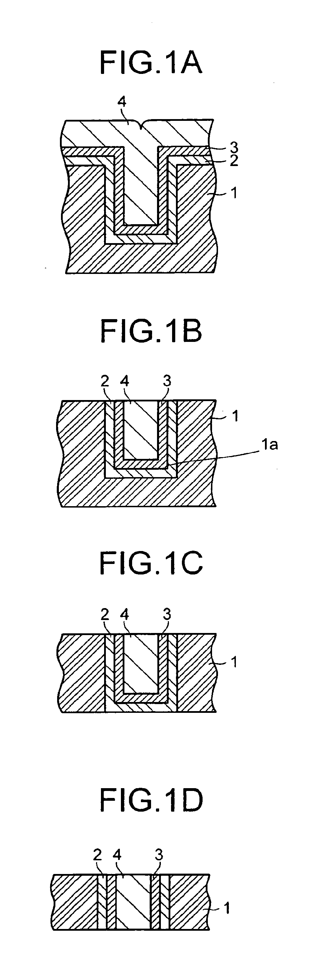

FIGs. 1A to 1D are schematic cross-sectional views of a semiconductor device schematically illustrating a polishing process by a CMP when forming a through silicon via. This polishing process includes a front-surface polishing step in which a silicon substrate is polished from an integrated circuit forming surface (front surface) side thereof to be planarized (step of polishing from a state in FIG. 1A to a state in FIG. 1B), and a rear-surface polishing step in which a rear surface being an opposite side of the integrated circuit forming surface of the silicon substrate is polished to expose the metal electrode (step of polishing from a state in FIG. 1B to a state in FIG. 1D via a state in FIG. 1C).

In the formation of the through silicon via, a front surface of a silicon substrate 1 is first subjected to deep etching to form a concave portion 1a, an insulating layer 2 made of silicon oxide is formed on the silicon substrate 1 including the concave portion 1a, a barrier layer 3 is then formed, and further, metal such as Cu is deposited on the barrier layer 3 so as to be embedded in the concave portion 1a, to thereby form a wiring metal layer 4 (FIG. 1A).

Next, polishing is performed from the front surface side of the silicon substrate 1, and after the wiring metal layer 4, the barrier layer 3 and the insulating layer 2 are polished to be planarized as illustrated in FIG. 1B, the rear-surface is polished. In the rear-surface polishing step, the CMP is conducted in a thickness direction by setting the rear surface of the silicon substrate 1 as a first surface to be polished. Further, the insulating layer 2 (silicon oxide layer) exposed as illustrated in FIG. 1C is polished together with the silicon substrate 1, the exposed barrier layer 3 is further polished, and finally, as illustrated in FIG. 1D, heights of the exposed wiring metal layer 4, barrier layer 3, and insulating layer 2 are aligned with a height of the rear surface of the silicon substrate 1, to thereby planarize the surface to be polished. As above, the metal electrode is formed.

The polishing slurry according to the first embodiment of the present invention can be suitably used for the rear-surface polishing step. Specifically, it is easy to control a polishing rate with respect to each of silicon that forms the silicon substrate 1, silicon oxide that forms the insulating layer 2, and metals that form the wiring metal layer 4 and the barrier layer 3. Accordingly, it is possible to align the height of an exposed surface of the metal electrode (wiring metal layer 4) with the height of the rear surface of the silicon substrate 1, and to planarize the entire surface to be polished including the insulating layer 2 (silicon oxide layer) and the barrier layer 3. Further, as described above, it is also possible that the metal electrode is also once polished to planarize the rear surface of the silicon substrate, silicon and silicon oxide layer and the like around the electrode are then removed by etching to make a tip of the metal electrode to be projected from the rear surface of the silicon substrate 1, and a height of the projecting portion is controlled with high accuracy in a range of 5 to 15 µm, for example, as described above.

When the polishing slurry in the first embodiment of the present invention is used in the CMP process for the above-described rear-surface polishing, a high effect can be achieved particularly when the barrier layer 3 is a layer made of one kind or more selected from tantalum (Ta), a Ta alloy, TaN, titanium (Ti), a Ti alloy, and TiN.

Further, when the aforementioned wiring metal layer 4 is made of copper (Cu) or a Cu alloy, a high effect can be achieved by the polishing slurry in the first embodiment of the present invention. However, it is also possible to apply the polishing slurry to a metal layer made of metal other than Cu, such as, for example, aluminum (Al), nickel (Ni), or tungsten (W).

### (1-3) Polishing Method

A method of polishing a surface to be polished of a semiconductor device by using the polishing slurry in the first embodiment of the present invention is preferably a polishing method in which the surface to be polished of the semiconductor device and a polishing pad are brought into contact with each other while supplying the polishing slurry to the polishing pad, and polishing is performed by a relative movement between them.

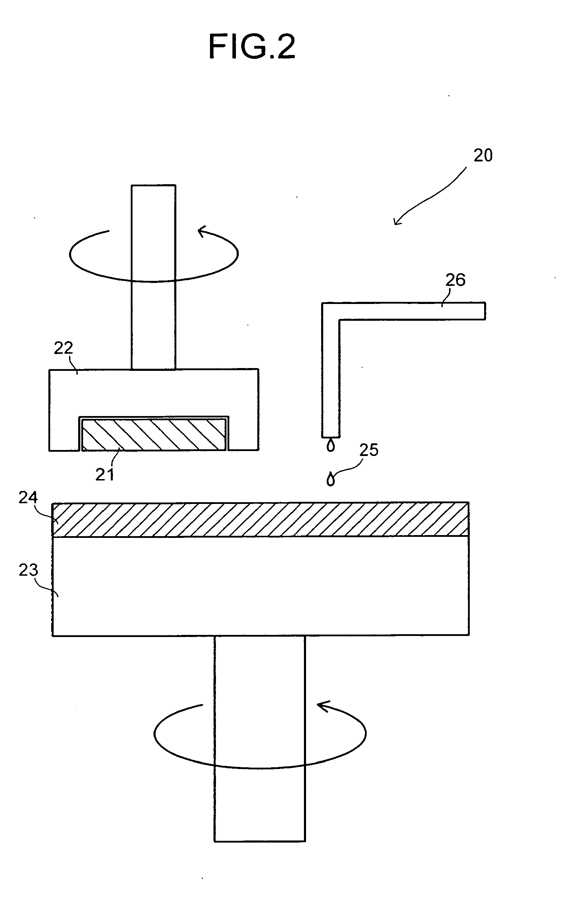

In the above-described polishing method, as a polishing apparatus, a well-known polishing apparatus can be used. FIG. 2 is a diagram illustrating an example of a polishing apparatus capable of being used in the first embodiment of the present invention. This polishing apparatus 20 includes a polishing head 22 that holds a semiconductor device 21, a polishing platen 23, a polishing pad 24 attached to a surface of the polishing platen 23, and a polishing slurry supply pipe 26 through which a polishing slurry 25 is supplied to the polishing pad 24. It is configured such that a surface to be polished of the device 21 held by the polishing head 22 is brought into contact with the polishing pad 24 while supplying the polishing slurry 25 from the polishing slurry supply pipe 26, and polishing is conducted by causing a relative rotary movement between the polishing head 22 and the polishing platen 23. Note that the polishing apparatus used in the embodiment of the present invention is not limited to one with such a structure.

It is also possible that the polishing head 22 performs not only the rotary movement but also a linear movement. Further, the polishing platen 23 and the polishing pad 24 may also have a size equal to or less than a size of the semiconductor device 21. In that case, it is preferable to design such that the polishing head 22 and the polishing platen 23 are relatively moved so that the entire surface of the surface to be polished of the semiconductor device 21 can be polished. Further, it is also possible that the polishing platen 23 and the polishing pad 24 are not designed to make the rotary movement, and may be of a belt type and move in one direction, for example.

Although there is no particular limitation regarding polishing conditions of such a polishing apparatus 20, it is also possible to further increase a polishing pressure to improve a polishing rate by applying a load to the polishing head 22 to press it against the polishing pad 24. The polishing pressure is preferably about 0.5 to 50 kPa, and is more preferably about 3 to 40 kPa, from the viewpoint of the uniformity in the surface to be polished of the semiconductor device 21 regarding the polishing rate, the planarity, and the prevention of polishing defects such as scratches. A rotation speed of the polishing platen 23 and the polishing head 22 is preferably about 50 to 500 rpm, but is not limited to this. Further, an amount of the polishing slurry 25 to be supplied is appropriately adjusted and selected, based on a composing material of the surface to be polished, a composition of the polishing slurry, the aforementioned respective polishing conditions and the like.

As the polishing pad 24, a common one made of a nonwoven fabric, a polyurethane foam, a porous resin, a nonporous resin or the like can be used. Further, in order to facilitate the supply of the polishing slurry 25 to the polishing pad 24 or to make a certain amount of the polishing slurry 25 stay on the polishing pad 24, lattice-shaped grooves, concentric grooves, spiral grooves or the like may also be formed on a surface of the polishing pad 24.

According to need, it is also possible to conduct polishing while performing conditioning of the surface of the polishing pad 24 by making a pad conditioner to be brought into contact with the surface of the polishing pad 24.

### (2) Second Embodiment: Polishing slurry and Polishing Method-Used for Planarization of Embedded Wiring

When performing a planarization of embedded wiring, a surface to be polished does not include a surface made of silicon, different from the rear-surface polishing when forming the through silicon via, according to the first embodiment. The second embodiment is applied to a process in which a surface to be polished including each of a surface made of silicon oxide, and a surface made of metal (which is also described as, including each of silicon oxide and metal, hereinafter) is polished to be planarized. Note that the "surface to be polished" means a surface at an intermediate stage which appears in a process of manufacturing the semiconductor device.

### (2-1) Polishing slurry

A polishing slurry in the second embodiment of the present invention contains each of cerium oxide particles, a complexing agent, and water. By using this polishing slurry, when the surface to be polished of the semiconductor device contains each of silicon oxide and metal, the control of polishing rate is easy, and accordingly, in a manufacturing process of the semiconductor device, it is possible to form a metal wiring (embedded wiring) with high planarity by polishing each of silicon oxide and metal.

In the polishing slurry in the second embodiment of the present invention, the cerium oxide particles are polishing abrasive particles, and cerium oxide particles similar to those explained in the first embodiment can be used. Further, regarding the complexing agent and the water, it is also possible to use a complexing agent and water similar to those explained in the first embodiment.

The polishing slurry in the second embodiment may contain a dispersing agent similar to that of the first embodiment. Further, the polishing slurry may also contain an oxidizing agent. Furthermore, since the polishing slurry is used for polishing the surface to be polished including silicon oxide and metal, but no silicon, it is not particularly required to add a pH adjusting agent, but, it is also possible to add a pH adjusting agent similar to that of the first embodiment. When the polishing properties of the polishing slurry are taken into consideration, the pH is preferably adjusted to fall within a range of 9 to 14.

### (2-2) Surface to be Polished of Semiconductor Device

The polishing slurry in the second embodiment of the present invention is suitable for a CMP process of polishing a surface to be polished on which a wiring metal layer, a barrier layer and an insulating layer are formed.

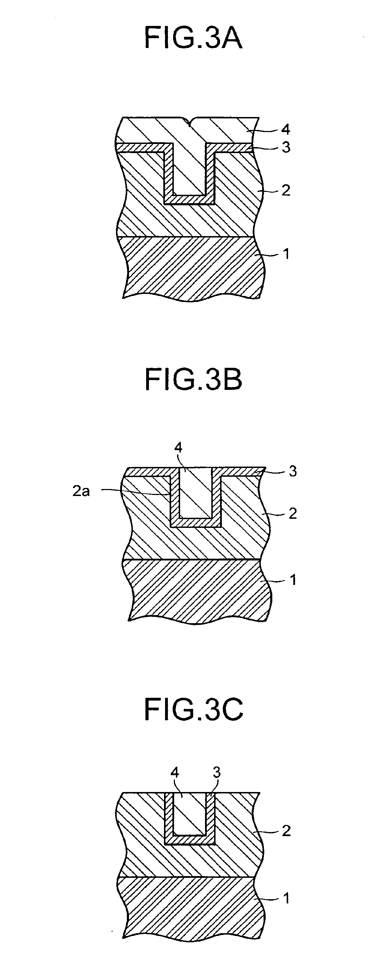

More concretely, the polishing slurry is suitably used for a polishing process for performing a planarization of embedded wiring, as illustrated in FIGs. 3A to 3C. In the planarization of the embedded wiring, at first, as illustrated in FIG. 3A, a groove portion 2a or the like for wiring is formed on a silicon oxide layer being an insulating layer 2 on a silicon substrate 1, a barrier layer 3 is formed thereon, and metal such as Cu, for example, is then deposited so as to be embedded in the groove portion 2a, to thereby form a wiring metal layer 4. Next, polishing is performed in a thickness direction by setting a surface of the wiring metal layer 4 as a first surface to be polished, and when the barrier layer 3 is exposed as illustrated in FIG. 3B, the wiring metal layer 4 and the barrier layer 3 are polished, and the surface of the insulating layer 2 except for the groove portion 2a is exposed and planarized. As above, the planarized embedded metal wiring is formed, as illustrated in FIG. 3C.

When the polishing slurry in the second embodiment of the present invention is used in the CMP process for performing the planarization of the embedded wiring described above, a high effect can be achieved particularly when the barrier layer 3 is a layer made of one kind or more selected from Ta, a Ta alloy, TaN, Ti, a Ti alloy, and TiN. Further, when the aforementioned wiring metal layer 4 is made of Cu or a Cu alloy, a high effect can be achieved by the polishing slurry in the second embodiment of the present invention, and the polishing slurry can also be applied to a metal layer made of metal other than Cu, such as, for example, Al, Ni, or W.

### (2-3) Polishing Method

A method of polishing a surface to be polished of a semiconductor device by using the polishing slurry in the second embodiment of the present invention is preferably a method in which the surface to be polished of the semiconductor device and a polishing pad are brought into contact with each other while supplying the polishing slurry to the polishing pad, and polishing is performed by a relative movement between them, similar to the polishing method using the polishing slurry in the first embodiment.

Further, as a polishing apparatus used in this polishing method, a well-known polishing apparatus can be used, similar to the above-described first embodiment. There is no particular limitation regarding polishing conditions when performing the polishing using the polishing slurry in the second embodiment of the present invention, and conditions similar to those of the above-described first embodiment can be cited as preferable conditions.

### Examples

Hereinafter, the present invention will be more concretely described based on examples and comparative examples, but, the present invention is not limited these examples. In the examples and the comparative examples, "%" means mass%, unless otherwise indicated. Further, characteristic values are measured and evaluated by the following methods.

### [pH]

The pH was measured at 25°C by using pH81-11 manufactured by Yokogawa Electric Corporation.

### [Average Particle Size of Abrasive Grains]

An average particle size of abrasive grains was determined by using a laser scattering/diffraction apparatus (trade name: LA-920, manufactured by Horiba, Ltd.).

### [Polishing Characteristics]

### (1) Polishing Conditions

Polishing was carried out by using an automatic CMP polishing apparatus (trade name: Mirra, manufactured by Applied Materials, Inc.). As a polishing pad, a two-layer pad IC-1400 k-groove manufactured by Rodel, Inc. was used, and for conditioning of the polishing pad, MEC100-PH3.5L manufactured by Mitsubishi Materials Corporation was used. A supply rate of a polishing slurry was set to 200 ml/minute. The polishing was conducted under conditions where a polishing pressure was 27.6 kPa, a rotation speed of a polishing platen was 127 rpm, and a rotation speed of a polishing head was 123 rpm. The polishing was conducted for 1 minute. Note that when polishing silicon, the polishing was conducted for 5 minutes as an exception.

### (2) Object to be Polished

The following objects to be polished were used for measuring polishing characteristics of polishing slurrys obtained in examples 1 to 13 and comparative examples 1 to 3. As an object to be polished of silicon, a 8-inch silicon wafer substrate whose one side was mirror-polished, was used, and a polishing rate of the substrate was measured. As an object to be polished of silicon oxide, a 8-inch silicon wafer substrate having a silicon oxide film deposited by a CVD method was used, and a polishing rate of the substrate was measured. Further, copper was used as metal, and as an object to be polished of copper, a 8-inch silicon wafer substrate having a copper film with a thickness of 2000 nm deposited on a silicon substrate through a wet plating, was used, and a polishing rate of the substrate was measured.

First, the following preparatory experiments were conducted to examine effects of a complexing agent.

### (Preparatory Experiment 1)

Cerium oxide particles with an average particle size of 0.17 µm and ammonium polyacrylate having an Mw of 5000 being a dispersing agent were mixed while being stirred in deionized water, to thereby prepare a slurry S. No agglomeration occurred in the slurry S, and no sedimentation occurred for 1 hour or more.

### (Preparatory Experiment 2)

When the slurry S was dropped in an aqueous solution of 0.1 % copper sulfate so that a concentration of cerium oxide became 0.1%, the agglomeration of cerium oxide occurred in an instant.

### (Preparatory Experiment 3)

There was prepared an aqueous solution by dissolving 1.0% of iminodiacetic acid in an aqueous solution of 0.1% copper sulfate. When the slurry S was dropped in this aqueous solution so that a concentration of cerium oxide became 0.1%, no agglomeration was observed.

The following can be understood from the preparatory experiments 1 to 3 described above. Although the slurry S itself being a cerium oxide dispersion liquid exhibits a good dispersion stability, when a copper ion exists in the slurry S, the agglomeration of cerium oxide particles is facilitated. However, when the copper ion forms a complex (chelate) with the use of iminodiacetic acid being a complexing agent, it can be understood that the agglomeration of cerium oxide is suppressed.

### (Example 1)

Cerium oxide particles with an average particle size of 0.17 µm and ammonium polyacrylate having an Mw of 5000 were mixed while being stirred in deionized water, to thereby prepare a polishing slurry A in which a concentration of cerium oxide particles and a concentration of ammonium polyacrylate with respect to the total mass of the solution became 10% and 0.07%, respectively.

Next, the polishing slurry A was diluted so that a concentration of cerium oxide particles became 0.05%, and potassium hydroxide being a basic compound and iminodiacetic acid being a complexing agent were then added to the diluted polishing slurry A, to thereby prepare a polishing slurry B in which a concentration of potassium hydroxide was 0.67%, and a concentration of iminodiacetic acid was 0.5%. A pH of the polishing slurry B is presented in Table 1 together with the composition.

### (Examples 2 to 6)

Potassium hydroxide and iminodiacetic acid were added to the polishing slurry A which was diluted to make a concentration of cerium oxide particles to be 0.05%, to prepare a polishing slurry B, and then ammonium persulfate being an oxidizing agent was further added to each of the polishing slurrys B so that concentrations of ammonium persulfate became 0.2%, 0.4%, 0.5%, 0.8%, and 1.0%, respectively, as presented in Table 1, to thereby prepare polishing slurry in examples 2 to 6. The composition and the pH of each of these polishing slurrys are presented in Table 1.

### (Example 7)

Potassium hydroxide and iminodiacetic acid, and ammonium persulfate being an oxidizing agent were added to the polishing slurry A which was diluted to make a concentration of cerium oxide particles to be 0.05%, to thereby prepare a polishing slurry in which a concentration of potassium hydroxide was 0.67%, a concentration of iminodiacetic acid was 0.7%, and a concentration of ammonium persulfate was 0.8%, as presented in Table 1. The composition and the pH of this polishing slurry are presented in Table 1.

### (Example 8)

Potassium hydroxide, succinimide being a complexing agent, and ammonium persulfate were added to the polishing slurry A which was diluted to make a concentration of cerium oxide particles to be 0.05%, to thereby prepare a polishing slurry in which a concentration of potassium hydroxide was 0.67%, a concentration of succinimide was 0.5%, and a concentration of ammonium persulfate was 0.5%, as presented in Table 1. The composition and the pH of this polishing slurry are presented in Table 1.

### (Example 9)

Potassium hydroxide, glycylglycine being a complexing agent, and ammonium persulfate were added to the polishing slurry A which was diluted to make a concentration of cerium oxide particles to be 0.05%, to thereby prepare a polishing slurry in which a concentration of potassium hydroxide was 0.40%, a concentration of glycylglycine was 0.5%, and a concentration of ammonium persulfate was 0.5%, as presented in Table 1. The composition and the pH of this polishing slurry are presented in Table 1.

### (Example 10)

Potassium hydroxide, picolinic acid being a complexing agent, and ammonium persulfate were added to the polishing slurry A which was diluted to make a concentration of cerium oxide particles to be 0.05%, to thereby prepare a polishing slurry in which a concentration of potassium hydroxide was 0.42%, a concentration of picolinic acid was 0.5%, and a concentration of ammonium persulfate was 0.5%, as presented in Table 1. The composition and the pH of this polishing slurry are presented in Table 1.

### (Example 11)

Monoethanolamine being a basic compound, iminodiacetic acid, and ammonium persulfate were added to the polishing slurry A which was diluted to make a concentration of cerium oxide particles to be 0.05%, to thereby prepare a polishing slurry in which a concentration of monoethanolamine was 1.34%, a concentration of iminodiacetic acid was 0.5%, and a concentration of ammonium persulfate was 0.5%, as presented in Table 1. The composition and the pH of this polishing slurry are presented in Table 1.

### (Examples 12 and 13)

Potassium hydroxide, iminodiacetic acid, and ammonium persulfate were added to each of the polishing slurrys A diluted to make a concentration of cerium oxide particles to be 0.25%, to thereby prepare polishing slurrys in which a concentration of potassium hydroxide was 0.67%, a concentration of iminodiacetic acid was 0.5%, and concentrations of ammonium persulfate were 0.4% and 0.5%, respectively, as presented in Table 1. The composition and the pH of each of these polishing slurrys are presented in Table 1.

(Comparative Example 1)The polishing slurry A was diluted to make a concentration of cerium oxide particles to be 0.05%, which was used as a polishing slurry in a comparative example 1. The composition and the pH of this polishing slurry are presented in Table 1.

### (Comparative Example 2)

Only potassium hydroxide was added to the polishing slurry A which was diluted to make a concentration of cerium oxide particles to be 0.05%, to thereby prepare a polishing slurry in which a concentration of potassium hydroxide was 0.67%. The composition and the pH of this polishing slurry are presented in Table 1.

### (Comparative Example 3)

Potassium hydroxide, and ammonium persulfate were added to the polishing slurry A which was diluted to make a concentration of cerium oxide particles to be 0.05%, to thereby prepare a polishing slurry in which a concentration of potassium hydroxide was 0.67%, and a concentration of ammonium persulfate was 1.0%, as presented in Table 1. The composition and the pH of this polishing slurry are presented in Table 1.

[Table 1]

| | CONCENTRATION OF CERIUM OXIDE MASS% | BASIC COMPOUND | | COMPLEXING AGENT | | OXIDIZING AGENT | | pH |
|---|---|---|---|---|---|---|---|---|
| | | NAME OF SUBSTANCE | MASS% | NAME OF SUBSTANCE | MASS% | NAME OF SUBSTANCE | MASS% | |
| EXAMPLE 1 | 0.05 | POTASSIUM HYDROXIDE | 0.67 | IMINODIACETIC ACID | 0.5 | NO SUBSTANCE | | 12.8 |
| EXAMPLE 2 | 0.05 | POTASSIUM HYDROXIDE | 0.67 | IMINODIACETIC ACID | 0.5 | AMMONIUM PERSULFATE | 0.2 | 12.6 |
| EXAMPLE 3 | 0.05 | POTASSIUM HYDROXIDE | 0.67 | IMINODIACETIC ACID | 0.5 | AMMONIUM PERSULFATE | 0.4 | 12.1 |
| EXAMPLE 4 | 0.05 | POTASSIUM HYDROXIDE | 0.67 | IMINODIACETIC ACID | 0.5 | AMMONIUM PERSULFATE | 0.5 | 11.6 |
| EXAMPLE 5 | 0.05 | POTASSIUM HYDROXIDE | 0.67 | IMINODIACETIC ACID | 0.5 | AMMONIUM PERSULFATE | 0.8 | 10.3 |
| EXAMPLE 6 | 0.05 | POTASSIUM HYDROXIDE | 0.67 | IMINODIACETIC ACID | 0.5 | AMMONIUM PERSULFATE | 1.0 | 10.0 |
| EXAMPLE 7 | 0.05 | POTASSIUM HYDROXIDE | 0.67 | IMINODIACETIC ACID | 0.7 | AMMONIUM PERSULFATE | 0.8 | 10.0 |
| EXAMPLE 8 | 0.05 | POTASSIUM HYDROXIDE | 0.67 | SUCCINIMIDE | 0.5 | AMMONIUM PERSULFATE | 0.5 | 10.0 |
| EXAMPLE 9 | 0.05 | POTASSIUM HYDROXIDE | 0.40 | GLYCYLGLYCINE | 0.5 | AMMONIUM PERSULFATE | 0.5 | 10.0 |
| EXAMPLE 10 | 0.05 | POTASSIUM HYDROXIDE | 0.42 | PICOLINIC ACID | 0.5 | AMMONIUM PERSULFATE | 0.5 | 10.0 |
| EXAMPLE 11 | 0.05 | MONOETHANOLAMI NE | 1.34 | IMINODIACETIC ACID | 0.5 | AMMONIUM PERSULFATE | 0.5 | 10.0 |
| EXAMPLE 12 | 0.25 | POTASSIUM HYDROXIDE | 0.67 | IMINODIACETIC ACID | 0.5 | AMMONIUM PERSULFATE | 0.4 | 10.6 |
| EXAMPLE 13 | 0.25 | POTASSIUM HYDROXIDE | 0.67 | IMINODIACETIC ACID | 0.5 | AMMONIUM PERSULFATE | 0.5 | 10.5 |
| COMPARATIVE EXAMPLE 1 | 0.05 | NO SUBSTANCE | - | NO SUBSTANCE | - | NO SUBSTANCE | - | 9.0 |
| COMPARATIVE EXAMPLE 2 | 0.05 | POTASSIUM HYDROXIDE | 0.67 | NO SUBSTANCE | - | NO SUBSTANCE | - | 13.0 |
| COMPARATIVE EXAMPLE 3 | 0.05 | POTASSIUM HYDROXIDE | 0.67 | NO SUBSTANCE | - | AMMONIUM PERSULFATE | 1.0 | 12.7 |

Next, measurement of each of polishing characteristics (polishing rates of copper, silicon, and silicon oxide, and presence/absence of polishing defects on copper examined by visual observation) of the polishing slurrys obtained in the examples 1 to 13 and the comparative examples 1 to 3, respectively, was conducted. Measured results are presented in Table 2.

**[Table 2]**

| | POLISHING RATE (µm/MINUTE) | | | POLISHING DEFECT ON COPPER |
|---|---|---|---|---|
| | COPPER | SILICON | SILICON OXIDE | |
| EXAMPLE 1 | 0.01 | 0.95 | 0.23 | ABSENCE |
| EXAMPLE 2 | 0.11 | 0.95 | 0.25 | ABSENCE |
| EXAMPLE 3 | 0.49 | 0.92 | 0.30 | ABSENCE |
| EXAMPLE 4 | 0.64 | 0.93 | 0.24 | ABSENCE |
| EXAMPLE 5 | 0.89 | 0.73 | 0.13 | ABSENCE |
| EXAMPLE 6 | 1.04 | 0.74 | 0.13 | ABSENCE |
| EXAMPLE 7 | 0.97 | 0.74 | 0.13 | ABSENCE |
| EXAMPLE 8 | 0.91 | 0.76 | 0.19 | ABSENCE |
| EXAMPLE 9 | 0.66 | 0.64 | 0.14 | ABSENCE |
| EXAMPLE 10 | 0.76 | 0.85 | 0.13 | ABSENCE |
| EXAMPLE 11 | 1.05 | 1.01 | 0.05 | ABSENCE |
| EXAMPLE 12 | 0.50 | 0.95 | 0.66 | ABSENCE |
| EXAMPLE 13 | 0.63 | 0.94 | 0.54 | ABSENCE |
| COMPARATIVE EXAMPLE 1 | 0.02 | EQUAL TO OR LOWER THAN LOWER LIMIT OF DETECTION | 0.24 | PRESENCE |
| COMPARATIVE EXAMPLE 2 | 0.02 | 0.86 | 0.26 | PRESENCE |
| COMPARATIVE EXAMPLE 3 | 0.52 | 0.96 | 0.31 | PRESENCE |

From the measured results in Table 2, it can be understood that, with the use of the polishing slurry (polishing slurry B) in the example 1 being the polishing slurry of the present invention, the polishing defect is not formed on copper, compared to a case where the polishing slurry in the comparative example 1 including no complexing agent is used. Further, from the polishing characteristics of the polishing slurrys in the examples 1 to 7, it can be understood that the polishing rate of copper can be adjusted by adjusting the concentration of the oxidizing agent. Further, from the polishing characteristics of the polishing slurrys in the examples 5, and 8 to 10, it can be understood that, when the complexing agent being an organic compound having a nitrogen atom and a carbonyl group and in which the number of carbon existed between the nitrogen atom and the carbonyl group is 2 or less, is used, it is possible to polish copper, silicon and silicon oxide at controlled polishing rates with no polishing defects formed on copper. Further, from the polishing characteristics of the polishing slurries in the example 5 and the example 11, it can be understood that the basic compound as the pH adjusting agent can also be selected. Furthermore, from the comparison between the polishing characteristics of the polishing slurry in the example 3 and the polishing characteristics of the polishing slurry in the example 12, or the comparison between the polishing characteristics of the polishing slurry in the example 4 and the polishing characteristics of the polishing slurry in the example 13, it can be understood that the polishing rate of silicon oxide can be controlled by adjusting the concentration of the cerium oxide particles.

In the polishing slurry in the first embodiment of the present invention, the polishing rate of silicon is preferably 0.7 µm/minute or more. Further, it is preferable that the polishing rates of copper and silicon oxide can be changed within a range of 0.1 to 1.2 µm/minute, so that it is possible to deal with the planarization in various electrode patterns, when forming electrodes. In the polishing slurry in the second embodiment of the present invention, the polishing rate of silicon oxide is preferably 0.1 µm/minute or more. Further, it is preferable that the polishing rate of copper can be changed within a range of 0.1 to 0.8 µm/minute, so that it is possible to deal with the planarization in various electrode patterns, when forming electrodes.

The present invention has been described in detail while referring to specific embodiments, but, it is obvious for a person skilled in the art that the invention can be variously modified and changed without departing from the scope and the spirit of the present invention. The present application is based on Japanese Patent Application No. 2010-076088, filed on March 29, 2010, and the content thereof is incorporated herein by reference.

### Industrial Applicability

According to a polishing slurry of the present invention, when polishing a surface to be polished including silicon oxide and metal, or a surface to be polished including silicon, silicon oxide and metal in a manufacture of a semiconductor device, it is possible to minutely control polishing rates of silicon oxide and metal, or polishing rates of silicon, silicon oxide and metal in a wide range. Therefore, the polishing slurry can be applied to polishing for forming an embedded electrode, rear-surface polishing at a time of forming a through silicon via, and the like.

### Explanation of Codes

1 ... silicon substrate, 2 ... insulating layer, 3 ... barrier layer, 4 ... wiring metal layer, 20 ... polishing apparatus, 21 ... semiconductor device, 22 ... polishing head, 23 ... polishing platen, 24 ... polishing pad, 25 ... polishing slurry, 26 ... polishing slurry supply pipe.

## Claims

1. A polishing slurry for chemical mechanical polishing on a surface to be polished including a surface made of silicon oxide and a surface made of metal, comprising
cerium oxide particles, a complexing agent, and water.

2. The polishing slurry according to claim 1,
wherein the surface to be polished further includes a surface made of silicon and the polishing slurry further comprises a pH adjusting agent with which a pH is set to fall within a range of 9 to 14.

3. The polishing slurry according to claim 2, wherein the pH adjusting agent is a basic compound.

4. The polishing slurry according to any one of claims 1 to 3, wherein the metal is at least one kind of metal selected from copper and an alloy thereof, tantalum and an alloy thereof, titanium and an alloy thereof, tungsten, aluminum, and nickel.

5. The polishing slurry according to any one of claims 1 to 4,
wherein the surface to be polished further includes a surface made of at least one kind of metal compound selected from tantalum nitride and titanium nitride.

6. The polishing slurry according to any one of claims 1 to 5,
wherein the complexing agent has 5 or more of complex ion stability constant with at least one kind of metal contained in the surface to be polished.

7. The polishing slurry according to claim 6, wherein the complexing agent has a nitrogen atom and a carbonyl group, and is an organic compound in which the nitrogen atom and the carbonyl group are directly bonded or bonded via an organic group having a carbon number of 2 or less.

8. The polishing slurry according to claim 6 or 7,
wherein the complexing agent is at least one selected from iminodiacetic acid, picolinic acid, succinimide, and glycylglycine.

9. The polishing slurry according to any one of claims 1 to 8, further comprising an oxidizing agent.

10. The polishing slurry according to claim 9,
wherein the oxidizing agent is peracid or a salt thereof.

11. The polishing slurry according to claim 10,
wherein the oxidizing agent is persulfuric acid or a salt thereof.

12. A manufacturing method of a semiconductor integrated circuit device including a silicon substrate having an integrated circuit, comprising a step of polishing, with the polishing slurry according to any one of claims 1 to 11, a surface to be polished on the silicon substrate including a surface made of silicon oxide and a surface made of metal.

13. The manufacturing method of the semiconductor integrated circuit device according to claim 12, wherein the surface to be polished further includes a surface made of silicon being a surface on an opposite side of an integrated circuit forming surface of the silicon substrate, and the step of polishing comprises polishing a surface to be polished including a surface made of metal conducted to the integrated circuit.

14. A polishing method of performing chemical mechanical polishing on a surface to be polished including a surface made of silicon oxide and a surface made of metal, comprising a step of polishing with a polishing slurry containing cerium oxide particles, a complexing agent, and water.

15. The polishing method according to claim 14,
wherein the surface to be polished further includes a surface made of silicon; and
wherein the polishing slurry further contains a pH adjusting agent with which a pH is set to fall within a range of 9 to 14.

16. The polishing method according to claim 15, wherein the pH adjusting agent is a basic compound.

17. The polishing method according to any one of claims 14 to 16,
wherein the metal is at least one kind of metal selected from copper and an alloy thereof, tantalum and an alloy thereof, titanium and an alloy thereof, tungsten, aluminum, and nickel.

18. The polishing method according to any one of claims 14 to 17,
wherein the surface to be polished further includes a surface made of at least one kind of metal compound selected from tantalum nitride and titanium nitride.

19. The polishing method according to any one of claims 14 to 18,
wherein the complexing agent has 5 or more of complex ion stability constant with at least one kind of metal contained in the surface to be polished.

20. The polishing method according to claim 19,
wherein the complexing agent has a nitrogen atom and a carbonyl group, and is an organic compound in which the nitrogen atom and the carbonyl group are directly bonded or bonded via an organic group having a carbon number of 2 or less.

21. The polishing method according to claim 19 or 20,
wherein the complexing agent is at least one selected from iminodiacetic acid, picolinic acid, succinimide, and glycylglycine.

22. The polishing method according to any one of claims 14 to 21,
wherein the polishing slurry further contains an oxidizing agent.

23. The polishing method according to claim 22,
wherein the oxidizing agent is peracid or a salt thereof.

24. The polishing method according to claim 23,
wherein the oxidizing agent is persulfuric acid or a salt thereof.

25. A manufacturing method of a semiconductor integrated circuit device including a silicon substrate having an integrated circuit, comprising a step of polishing, by the polishing method according to any one of claims 14 to 24, a surface to be polished on the silicon substrate including a surface made of silicon oxide and a surface made of metal.

26. The manufacturing method of the semiconductor integrated circuit device according to claim 25, wherein the surface to be polished further includes a surface made of silicon being a surface on an opposite side of an integrated circuit forming surface of the silicon substrate, and the step of polishing comprises polishing a surface to be polished including a surface made of metal conducted to the integrated circuit.
